# EUROPEAN PATENT APPLICATION

(11) **EP 3 992 168 A1**
(43) Date of publication of application: **04.05.2022**
(21) Application number: 20832252.9
(22) Date of filing: 24.06.2020
(51) Int. Cl.: C04B 35/053, C04B 35/443, C04B 35/453, C23C 14/34

(54) **OXIDE SINTERED BODY**

(30) Priority: 27.06.2019 JP 2019120056; 27.06.2019 JP 2019120057
(71) Applicant: Idemitsu Kosan Co.,Ltd., Tokyo 100-8321 (JP)
(72) Inventor: TOMAI, Shigekazu, Sodegaura-shi, Chiba 299-0293 (JP); UEOKA, Yoshihiro, Sodegaura-shi, Chiba 299-0293 (JP); KATSUMATA, Satoshi, Sodegaura-shi, Chiba 299-0293 (JP); SASAKI, Kenichi, Sodegaura-shi, Chiba 299-0293 (JP)
(74) Representative: Gille Hrabal Partnerschaftsgesellschaft mbB Patentanwälte
(86) International application number: PCT/JP2020/024740
(87) International publication number: WO 2020/262433

(57) **Abstract**

An oxide sintered body comprising zinc, magnesium, a positive trivalent or positive tetravalent metal element X, and oxygen as constituent elements, wherein an atomic ratio of the metal element X to the sum of the zinc, the magnesium, and the metal element X [X/(Zn+Mg+X)] is 0.0001 or more and 0.6 or less, and an atomic ratio of the magnesium to the sum of the zinc and the magnesium [Mg/(Zn+Mg)] is 0.25 or more and 0.8 or less.

## Description

### Technical Field

The invention relates to an oxide sintered body and a material for film formation used for forming a thin film.

### Background Art

MgO-ZnO-based oxides have been applied to translucent ceramics for a color liquid crystal projector (Patent Document 1), an oxide semiconductor (Patent Document 2), a transparent electrode (Patent Document 3), or the like. For example, Patent Document 3 discloses a sintered body in which the atomic ratio of Al/(Zn+Al+Mg) = 0.005 to 0.1, and the atomic ratio of Mg/(Zn+Al+Mg) = 0.001 to 0.05, composed of grains (a) containing zinc oxide and having a hexagonal wurtzite structure with an average grain size of 10 µm or less, and grains (b) containing aluminum and having a spinel structure with an average grain size of 5 µm or less.

The above-mentioned sintered bodies are a material with an emphasis on conductivity, and since ZnO is the main component, there is a problem in the translucency in the ultraviolet region.

### Related Art Documents

### Patent Documents

[Patent Document 1] JP 2009-184898 A1
[Patent Document 2] JP 2012-066968 A1
[Patent Document 3] JP 2011-063866 A1

### Summary of the Invention

It is an object of the invention to provide an oxide sintered body capable of giving a film having a high translucency in the ultraviolet region and a high conductivity.

The inventors have found that by forming a film using an oxide sintered body in which a positive trivalent or positive tetravalent metal element is added to Mg and Zn-based oxides at a specific concentration, a film having high translucency in the ultraviolet region and good conductivity can be obtained.

According to the invention, the following oxide sintered body and the like are provided.
1. An oxide sintered body comprising zinc, magnesium, a positive trivalent or positive tetravalent metal element X, and oxygen as constituent elements, wherein the atomic ratio of the metal element X to the sum of the zinc, the magnesium, and the metal element X [X/(Zn+Mg+X)] is 0.0001 or more and 0.6 or less, and the atomic ratio of the magnesium to the sum of the zinc and the magnesium [Mg/(Zn+Mg)] is 0.25 or more and 0.8 or less.
2. The oxide sintered body according to 1, wherein the atomic ratio [Mg/(Zn+Mg)] is 0.625 or more and 0.8 or less.
3. The oxide sintered body according to 1, wherein the atomic ratio [Mg/(Zn+Mg)] is 0.626 or more and 0.75 or less.
4. The oxide sintered body according to 1, wherein the atomic ratio [Mg/(Zn+Mg)] is 0.628 or more and 0.74 or less.
5. The oxide sintered body according to any one of 2 to 4, comprising cubic MgO into which Zn is solid solved, and MgX₂O₄ into which Zn is solid-solved, wherein X is a positive trivalent metal element.
6. The oxide sintered body according to 1, wherein the atomic ratio [Mg/(Zn+Mg)] is 0.25 or more and less than 0.625.
7. The oxide sintered body according to 1, wherein the atomic ratio [Mg/(Zn+Mg)] is 0.30 or more and 0.60 or less.
8. The oxide sintered body according to 1, wherein the atomic ratio [Mg/(Zn+Mg)] is 0.40 or more and 0.59 or less.
9. The oxide sintered body according to any one of 6 to 8, comprising cubic MgO into which Zn is solid-solved, hexagonal ZnO into which Mg is solid-solved, and MgX₂O₄ into which Zn is solid-solved, wherein X is a positive trivalent metal element.
10. The oxide sintered body according to any one of 1 to 9, wherein the atomic ratio [X/(Zn+Mg+X)] is 0.003 or more and 0.6 or less.
11. The oxide sintered body according to any one of 1 to 9, wherein the atomic ratio [X/(Zn+Mg+X)] is 0.007 or more and 0.5 or less.
12. The oxide sintered body according to any one of 1 to 9, wherein the atomic ratio [X/(Zn+Mg+X)] is 0.008 or more and 0.5 or less.
13. The oxide sintered body according to any one of 1 to 9, wherein the atomic ratio [X/(Zn+Mg+X)] is 0.01 or more and 0.5 or less.
14. The oxide sintered body according to any one of 1 to 13, wherein X is at least one of Al and Ga.
15. The oxide sintered body according to 14, wherein X is Al.
16. The oxide sintered body according to 14, wherein X is Ga.
17. A material for film formation, comprising the oxide sintered body according to any one of 1 to 16.
18. The material for film formation according to 17, which is a tablet for film formation.
19. The material for film formation according to 17, which is a sputtering target.
20. A thin film obtained by using the material for film formation according to any one of 17 to 19.

According to the invention, an oxide sintered body capable of obtaining a film having high translucency in the ultraviolet region and a high conductivity can be provided.

### Brief Description of the Drawings

Figure 1 is a diagram showing a result of analysis of the XRD chart of the oxide sintered body of Example 1.
Figure 2 is a diagram showing a result of analysis of the XRD chart of the oxide sintered body of Example 2.
Figure 3 is a diagram showing a result of analysis of the XRD chart of the oxide sintered body of Comparative Example 1.
Figure 4 is a diagram showing a result of analysis of the XRD chart of the oxide sintered body of Example 7.
Figure 5 is a diagram showing a result of analysis of the XRD chart of the oxide sintered body of Example 8.
Figure 6 is a diagram showing a result of analysis of the XRD chart of the oxide sintered body of Comparative Example 2.

### Mode for Carrying out the Invention

The oxide sintered body according to one aspect of the invention contains zinc (Zn), magnesium (Mg), a positive trivalent or positive tetravalent metal element (X), and oxygen (O) as constituent elements. In addition, the atomic ratio [X/(Zn+Mg+X)] is 0.0001 or more and 0.6 or less, and the atomic ratio [Mg/(Zn+Mg)] is 0.25 or more and 0.8 or less.

In this embodiment, examples of the positive trivalent or positive tetravalent metal element X include Al, Ga, In, Sc, and Y. The positive trivalent or positive tetravalent metal element X is preferably Al and/or Ga, more preferably Al. By containing Al, the relative density of the oxide sintered body is increased. A high relative density means that fewer voids that may be the cause of abnormal discharges or nodule generation during film formation are present, and therefore, when the oxide sintered body is used as a sputtering target, for example, stable sputtering can be performed with fewer cracks during sputtering, etc.

The atomic ratio [X/(Zn+Mg+X)] is 0.0001 or more and 0.6 or less. By using an oxide sintered body satisfying the atomic ratio range, the oxide sintered body can give a film which is compatible in both the translucency of the ultraviolet region and the conductivity.

The atomic ratio [X/(Zn+Mg+X)] may be 0.006 or more, may be more than 0.007, may be 0.008 or more, or may be 0.01 or more. The atomic ratio [X/(Zn+Mg+X)] may be 0.5 or less, may be 0.2 or less, or may be 0.1 or less.

The atomic ratio [Mg/(Zn+Mg)] is 0.25 or more and 0.8 or less. By using an oxide sintered body satisfying the atomic ratio range, the oxide sintered body can give a film which is compatible in both the translucency of the ultraviolet region and the conductivity. Incidentally, when an oxide sintered body having an atomic ratio exceeding 0.8 is used for film formation, even when a film obtained from the oxide sintered body is annealed, it is impossible to obtain a film having a high conductivity. On the other hand, when an oxide sintered body having an atomic ratio of less than 0.25 is used for film formation, only a film having a low ultraviolet transmittance can be obtained.

In one embodiment, the atomic ratio [Mg/(Zn+Mg)] is 0.625 or more and 0.8 or less. By using an oxide sintered body satisfying the atomic ratio range, the oxide sintered body can give a film mainly having excellent translucency in the ultraviolet region.

The atomic ratio [Mg/(Zn+Mg)] may be 0.626 or more, or may be 0.628 or more. The atomic ratio [Mg/(Zn+Mg)] may be 0.75 or less, may be 0.70 or less, or may be 0.67 or less.

In one embodiment, the atomic ratio [Mg/(Zn+Mg)] is 0.25 or more and less than 0.625. By using an oxide sintered body satisfying the atomic ratio range, the oxide sintered body can give a film mainly having excellent conductivity.

The atomic ratio [Mg/(Zn+Mg)] may be 0.30 or more, or may be 0.40 or more. The atomic ratio [Mg/(Zn+Mg)] may be 0.60 or less, or may be 0.55 or less.

The atomic ratios of zinc, magnesium, and the metal element X can be adjusted by setting the atomic ratios of the starting raw materials. The atomic ratios in the oxide sintered body tend to have an atomic ratio of zinc higher than that in the starting raw materials, and to have an atomic ratio of the metal element X almost the same as that in the starting raw materials.

The atomic ratio of each element contained in the oxide sintered body can be obtained by analyzing the elements contained in the oxide sintered body by using an inductively coupled plasma atomic emission spectroscopy (ICP-AES). Specifically, when a solution sample is atomized with a nebulizer and introduced into an argon plasma (about 5000 to 8000°C). The elements in the sample absorb thermal energy to be excited. Orbital electrons move from the ground state to orbitals with higher energy levels, and then move to orbitals with lower energy levels. At this time, a difference between the energy levels is put out as light to emit light. Since this emitted light has a wavelength (spectral line) intrinsic to an element, the existence of the element can be confirmed based on the presence or absence of the spectral line (qualitative analysis). Further, since the amplitude of the spectral line (emission intensity) of an element is proportional to the number of the elements in the sample, the concentration of the element in the sample can be determined by being compared with standard solutions each having a known concentration (quantitative analysis). The elements contained in the sample are specified by the qualitative analysis, and then the content of each of the elements is determined by the quantitative analysis. As a result, the atomic ratio of each of the elements is determined.

The elements constituting the oxide sintered body of this embodiment may consist essentially of Mg, Zn, the metal element X, and O. For example, 70 mol% or more, 80 mol% or more, or 90 mol% or more of the elements constituting the oxide sintered body of this embodiment may be Mg, Zn, the metal element X, and O. Further, the element constituting the oxide sintered body of this embodiment may consist of Mg, Zn, the metal element X, and O. In this case, the sintered body may contain inevitable impurities.

When the atomic ratio [Mg/(Zn+Mg)] is 0.625 or more and 0.8 or less, the oxide sintered body contains cubic MgO into which Zn is solid-solved, and MgX₂O₄ into which Zn is solid-solved, wherein X is a positive trivalent metal element. When the atomic ratio [Mg/(Zn+Mg)] is 0.25 or more and less than 0.625, the oxide sintered body contains cubic MgO into which Zn is solid-solved, hexagonal ZnO into which Mg is solid-solved, and MgX₂O₄ into which Zn is solid-solved, wherein X is a positive trivalent metal element. Thus, even when relatively lightweight metal oxides are used, an oxide sintered body having a high density can be obtained.

The fact that the oxide sintered body contains each of the above oxides can be confirmed by collating the X-ray diffraction (XRD) chart obtained by the XRD method with the database (PDF: Powder Diffraction File) provided by ICDD (International Centre for Diffraction Data). Further, the fact that each crystal is dissolved other metal elements as a solid solution can be determined by comparing the lattice constant determined by XRD (measured value) and the lattice constant described in PDF (PDF value). For example, in the case of a crystal in which Zn is dissolved as a solid solution, the measured value becomes larger than the PDF value.

The oxide sintered body of this embodiment can be produced, for example, by a step of mixing raw material powders to prepare a mixed powder, a step of molding the mixed powder into a molded body, and a step of firing the molded body.

As the starting raw materials, a powder of a compound containing Mg, a powder of a compound containing Zn, and a powder of a compound containing a metal element X can be used. As such a compound, an oxide of each element is preferable. Examples of such compounds include MgO, ZnO, Al₂O₃, and Ga₂O₃.

The mixing ratio of the raw material powders may be adjusted, for example, by taking into consideration of the atomic ratio of an oxide sintered body intended to obtain.

The average particle diameter of the raw material powder is preferably 0.1 to 1.2 µm, and more preferably 0.5 to 1.0 µm. The average particle diameter of the raw material powder can be measured by a laser diffraction particle size distribution apparatus or the like.

The methods of mixing and molding the raw materials are not particularly limited, and known methods can be employed. In addition, a binder may be added when mixing the raw materials.

Mixing of the raw materials may be performed using a known apparatus such as, for example, a ball mill, a bead mill, a jet mill, or an ultrasonic apparatus. The mixing time may be appropriately adjusted and is preferably about 6 to 100 hours.

As the method of molding, for example, a method wherein the mixed powder is pressurized and molded into a molded body can be given. By this step, the molded body can be formed into a product shape (e.g., a shape suitable as a sputtering target).

The mixed powder is filled in a mold, and pressure of 1000 kg/cm² or more is applied to the mixed powder usually by means of a mold press or a cold isostatic press (CIP) to obtain a molded body.

Note that, at the time of molding, a molding aid such as polyvinyl alcohol, polyethylene glycol, methylcellulose, Polywax, oleic acid, or stearic acid may be used.

An oxide sintered body can be obtained by heating the molded body obtained at a temperature of, for example, 1200 to 1650°C for 2 hours or more.

The heating temperature is preferably 1350 to 1600°C, more preferably 1400 to 1600°C, and still more preferably 1450 to 1500°C. The heating time is preferably 2 to 72 hours, more preferably 3 to 48 hours, and still more preferably 4 to 24 hours.

In the firing step, the molded body is usually heated in an air atmosphere or an oxygen gas atmosphere. The oxygen gas atmosphere is preferably an atmosphere having an oxygen concentration of, for example, 10 to 50% by volume.

The oxide sintered body of this embodiment can be suitably used as a material for film formation used for forming a thin film having a composition same as the oxide sintered body, for example, a tablet or a sputtering target used for film formation by a vacuum deposition method or an ion plating method. The thin film obtained from the material for film formation of this embodiment can be used as a transparent conductive film used for an electrode substrate such as an ultraviolet emitting diode, an ultraviolet emitting laser diode, or the like.

Note that heat treatment of the film at a high temperature after film formation improves the ultraviolet transmittance and conductivity of the film. The film just after film formation is in a state that zinc oxide, magnesium oxide, and the like are uniformly mixed. It is presumed that heat treatment of the film in that state causes aggregation, separation, and the like of the oxides, resulting in zinc oxide forming a network to develop conductivity, while aggregation of magnesium oxide in gaps in the zinc oxide network to transmit ultraviolet rays.

The heat treatment temperature of the electrode layer is preferably 750°C or higher, more preferably 900°C or higher.

The tablet can be produced, for example, by cutting and processing, or polishing an oxide sintered body which is obtained by firing a raw material molded into a desired shape. The sputtering target can be produced, for example, by cutting and processing, or polishing the oxide sintered body, followed by bonding it to the backing plate.

The uneven surface can be removed by cutting and processing. The oxide sintered body can be of a specified size. The surface may be polished with #200, #400, or even #800. By the polishing, the abnormal discharge and the occurrence of particles during sputtering can be suppressed.

A sputtering target can be obtained by cleaning the polished oxide sintered body as necessary, followed by application of a bonding metal such as metal indium solder to a surface of the oxide sintered body to be bonded, and bonding the surface to a backing plate.

### Examples

### Example 1

### (A) Production of oxide sintered body

AZinc oxide (ZnO) powder having an average particle diameter of 1 µm or less, a magnesium oxide (MgO) powder having an average particle diameter of 1 µm or less, and a gallium oxide (Ga₂O₃) powder having an average particle diameter of 1 µm or less were weighed and mixed so that the atomic ratio of each metal was as shown in Table 1. The mass fraction of the mixed powder was 43.9% by mass of ZnO, 40.8% by mass of MgO, and 15.3% by mass of Ga₂O₃.

The mixed powder was placed in a resin-made pot, then water was added thereto, and the mixture was mixed in a wet ball mill for 20 hours using hard ZrO₂ balls as grinding media. The resulting mixed slurry was taken out from the pot, collected by filtration, dried, and granulated. The obtained granulated product was placed in a mold and pressed to 3 ton/cm² by a cold isostatic press into a molded body.

The obtained molded body was placed in a sintering furnace, and the molded body was fired while oxygen was flowed in at a rate of 5 L/min per 0.1 m³ of the internal volume of the furnace.

The temperature in the sintering furnace was raised at 1°C/min from room temperature to 1000°C, and at 3°C/min from 1000°C to 1470°C, and the firing was performed at 1470°C for 5 hours. Subsequently, the inflow of oxygen was stopped, and the temperature in the furnace was lowered at 10°C/min from 1470°C to 1300°C. Then, the temperature in the furnace was maintained at 1300°C for 3 hours while Ar was flowed in at a rate of 10 L/min per 0.1m³ of the internal volume of the furnace. After left to cool, the oxide sintered body was obtained.

The composition and the relative density of the obtained oxide sintered body were evaluated. The results are shown in Table 2.

**Table 1**

| | Atomic ratios of starting raw materials | | | | |
|---|---|---|---|---|---|
| | Mg | Zn | X | Mg/(Zn+Mg) | X/(Zn+Mg+X) |
| Ex. 1 | 0.590 | 0.315 | Ga:0.095 | 0.652 | 0.095 |
| Ex. 2 | 0.590 | 0.315 | Al:0.095 | 0.652 | 0.095 |
| Ex. 3 | 0.380 | 0.120 | Ga:0.500 | 0.760 | 0.500 |
| Ex. 4 | 0.630 | 0.360 | Al:0.010 | 0.636 | 0.010 |
| Ex. 5 | 0.628 | 0.369 | Al:0.003 | 0.630 | 0.003 |
| Ex. 6 | 0.626 | 0.367 | Al:0.007 | 0.630 | 0.007 |
| Comp. Ex. 1 | 0.650 | 0.350 | 0 | 0.650 | 0 |

**Table 2**

| | Atomic ratios in oxide sintered body | | | | | Relative density (%) |
|---|---|---|---|---|---|---|
| | Mg | Zn | X | Mg/(Zn+Mg) | X/(Zn+Mg+X) | |
| Ex. 1 | 0.582 | 0.318 | Ga:0.100 | 0.647 | 0.100 | 89 |
| Ex. 2 | 0.582 | 0.318 | Al:0.100 | 0.647 | 0.100 | 100 |
| Ex. 3 | 0.370 | 0.130 | Ga:0.500 | 0.740 | 0.500 | 80 |
| Ex. 4 | 0.623 | 0.367 | Al:0.010 | 0.629 | 0.010 | 95 |
| Ex. 5 | 0.626 | 0.371 | Al:0.003 | 0.628 | 0.003 | 89 |
| Ex. 6 | 0.624 | 0.369 | Al:0.007 | 0.628 | 0.007 | 89 |
| Comp. Ex. 1 | 0.640 | 0.360 | 0 | 0.640 | 0 | 88 |

Evaluation methods are described below.

### (1) Atomic ratio of the metal element in the oxide sintered body

A part of the obtained oxide sintered body was cut out, dissolved in an acid, followed by analysis using an inductively coupled plasma atomic emission spectrometer.

### (2) Relative density

The relative density was calculated by measuring the actual density of the oxide sintered body by the Archimedes method using water and dividing the actual density by the theoretical density calculated based on the composition. The theoretical density was calculated based on the mass fractions of a MgO crystal without oxygen defects, an oxide of Zn, and an oxide of X (Ga or Al).

### (3) XRD measurement

Measurements were performed with the following equipment under the following conditions.
- Equipment: Ultima-III, manufactured by Rigaku Corporation
- X-ray: Cu-Kα ray (wavelength: 1.5406 A, monochromatized by graphite monochromator)
- 2θ-θ reflection method, continuous scan (1.0°/min)
- Sampling interval: 0.02°
- Slit DS, SS: 2/3°, RS: 0.6 mm

The result of XRD measurement was analyzed using a integrated powder X-ray analysis software (provided by Rigaku Corporation, PDXL2) to determine the crystal structures and lattice constants contained in the oxide sintered body. The crystal structures were confirmed by ICDD (PDF) cards described below.
ZnO: 01-079-205 (hexagonal)
ZnO: 01-077-0191 (cubic)
MgO: 01-071-1176 (cubic)
MgAl₂O₄: 01-084-0377
MgGa₂O₄: 01-073-1721

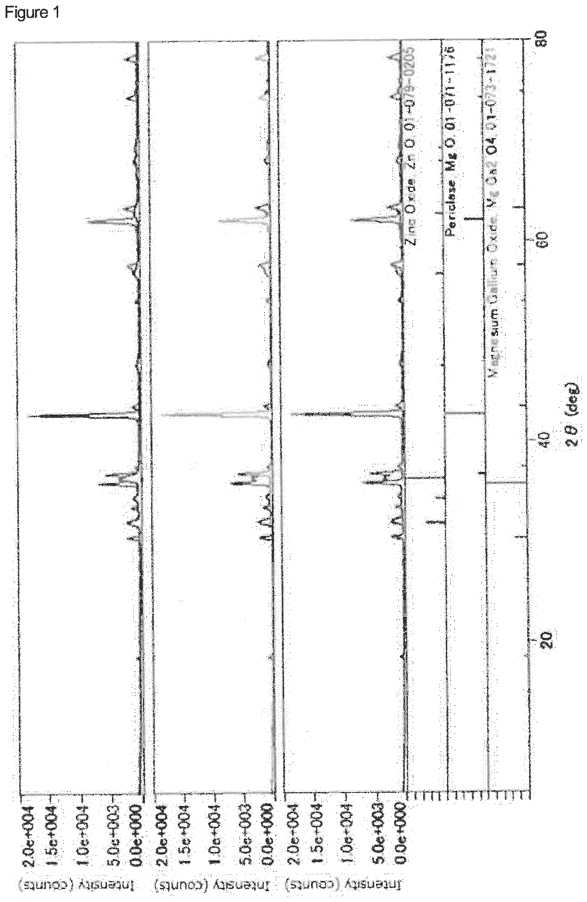

Fig. 1 shows a result of the analysis of the XRD chart. From Fig. 1, it was confirmed that the oxide sintered body contained ZnO, MgO, and MgGa₂O₄ as crystal structures.

Based on the measured values of lattice constants and PDF values, the existence of MgO into which Zn was solid-solved and MgX₂O₄ (X = Ga or Al) into which Zn was solid-solved was evaluated.

For the lattice constant "a" of MgO, the measured value was 4.2314 and the PDF value was 4.217. For the lattice constant "a" of ZnO, the measured value was 3.2423 and the PDF value was 3.242. For the lattice constant "a" of MgGa₂O₄, the measured value was 8.3116 and the PDF value was 8.26. From these results, it can be confirmed that the difference between the lattice constant "a" of MgO and that of MgGa₂O₄ is large, and it was determined that Zn is solid-solved into these crystals. When the lattice constant was changed by 0.01 or more, it was determined that Zn is solid-solved.

The results are shown in Table 3. In the table, the case where each crystal structure is contained is denoted by "∘", and the case where each crystal structure is not contained is denoted by "×".

**Table 3**

| | MgO into which Zn was solid-solved | MgX₂O₄ into which Zn was solid-solved X=Ga or Al |
|---|---|---|
| Ex. 1 | ○ | ○ |
| Ex. 2 | ○ | ○ |
| Ex. 3 | ○ | ○ |
| Ex. 4 | ○ | ○ |
| Ex. 5 | ○ | ○ |
| Ex. 6 | ○ | ○ |
| Comp. Ex. 1 | ○ | × |

### (B) Production of sputtering target

The obtained oxide sintered body was polished with a cup grinding wheel on a surface that would be the sputtered surface and processed to 100 mm in diameter and 5 mm in thickness. Using an In-based alloy, the backing plate was bonded to the polished oxide sintered body to obtain a sputtering target.

A thin film was actually formed using the sputtering target produced from the oxide sintered body and evaluated. The conditions for the film formation were as follows.

A sapphire substrate (thickness: 0.5 mm) was placed in an ultrasonic cleaner and washed with trichloroethylene for 5 minutes, with acetone for 5 minutes, with methanol for 5 minutes, and finally with distilled water for 5 minutes.

This substrate was set in a sputtering system (ULVAC: ACS-4000). A film having a thickness of 100 nm was formed on the substrate by deposition at 25°C using Ar as a sputtering gas.

### (2) Heat treatment

The substrate on which the film was formed in the above (1) was subjected to heat treatment (activation annealing) at 950°C for 5 minutes in a nitrogen atmosphere. The surface resistance of the film undergone the heat treatment was measured using Loresta FP manufactured by Mitsubishi Chemical Corporation. Further, the ultraviolet transmittance was evaluated using a spectrophotometer (manufactured by Shimadzu Corporation: UV-2600) .

Evaluation results are shown in Table 4.

**Table 4**

| | Ultraviolet transmittance (%) | Resistance (Ωcm) |
|---|---|---|
| Ex. 1 | 30 | 100 |
| Ex. 2 | 30 | 100 |
| Ex. 3 | 40 | 1 × 10⁴ |
| Ex. 4 | 20 | 1 |
| Ex. 5 | 20 | 100 |
| Ex. 6 | 20 | 1000 |
| Comp. Ex. 1 | 35 | 1 × 10⁵ |

### Examples 2 to 6 and Comparative Example 1

Oxide sintered bodies and sputtering targets were produced and evaluated in the same manner as in Example 1 except that the raw materials were weighed and mixed so that the atomic ratio of each metal element was the value shown in Table 1. The results are shown in Tables 2 to 4. Incidentally, in Examples where the metal element X is Al, aluminum oxide having the average particle diameter of 1µm or less (Al₂O₃ powder) was used.

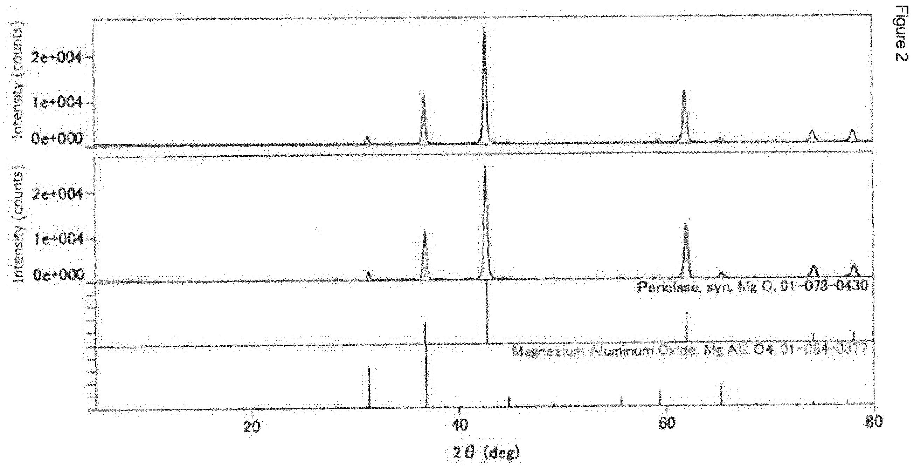

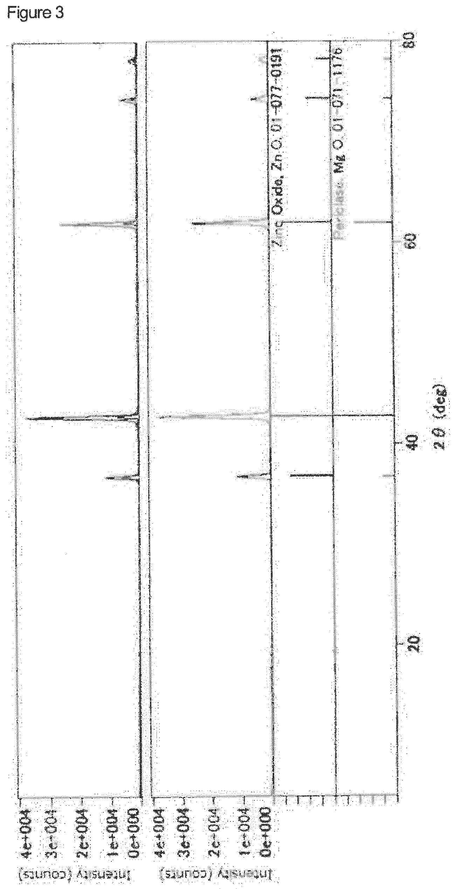

Fig. 2 shows a result of the analysis of the XRD chart of the oxide sintered body of Example 2. Fig. 3 shows a result of the analysis of the XRD chart of the oxide sintered body of Comparative Example 1.

### Example 7

### (A) Production of the oxide sintered body

A Zinc oxide (ZnO) powder having an average particle diameter of 1 µm or less, a magnesium oxide (MgO) powder having an average particle diameter of 1 µm or less, and a gallium oxide (Ga₂O₃ powder) having an average particle diameter of 1 µm or less were weighed and mixed so that the atomic ratio of each metal was as shown in Table 5. The mass fraction of the mixed powder was 48.9% by mass of ZnO, 36.3% by mass of MgO, and 14.8% by mass of Ga₂O₃.

The mixed powder was placed in a resin-made pot, then water was added thereto, and the mixture was mixed in a wet ball mill for 20 hours using hard ZrO₂ balls as grinding media. The resulting mixed slurry was taken out from the pot, collected by filtration, dried, and granulated. The obtained granulated product was placed in a mold and pressed to 3 ton/cm² by a cold isostatic press to obtain a molded body.

The obtained molded body was placed in a sintering furnace, and the molded body was fired while oxygen was flowed in at a rate of 5 L/min per 0.1 m³ of the internal volume of the furnace.

The temperature in the sintering furnace was raised at 1°C/min from room temperature to 1000°C, and at 3°C/min from 1000°C to 1470°C, and the firing was performed at 1470°C for 5 hours. Subsequently, the inflow of oxygen was stopped, and the temperature in the furnace was lowered at 10°C/min from 1470°C to 1300°C. Then, the temperature in the furnace was maintained at 1300°C for 3 hours while Ar was flowed in at a rate of 10 L/min per 0.1 m³ of the internal volume of the furnace. After left to cool, the oxide sintered body was obtained.

The composition and the relative density of the obtained oxide sintered body were evaluated in the same manner as in Example 1. The results are shown in Table 6.

**Table 5**

| | Atomic ratios of starting raw materials | | | | |
|---|---|---|---|---|---|
| | Mg | Zn | X | Mg/(Zn+Mg) | X/(Zn+Mg+X) |
| Ex. 7 | 0.543 | 0.362 | Ga:0.095 | 0.60 | 0.095 |
| Ex. 8 | 0.543 | 0.362 | Al:0.095 | 0.60 | 0.095 |
| Comp. Ex. 2 | 0.60 | 0.40 | 0 | 0.60 | 0 |
| Ex. 9 | 0.36 | 0.63 | Al:0.01 | 0.36 | 0.01 |
| Ex. 10 | 0.13 | 0.37 | Ga:0.50 | 0.26 | 0.50 |
| Ex. 11 | 0.538 | 0.459 | Al:0.003 | 0.54 | 0.003 |
| Ex. 12 | 0.536 | 0.457 | Al:0.007 | 0.54 | 0.007 |
| Ex. 13 | 0.535 | 0.455 | Al:0.01 | 0.54 | 0.01 |

**Table 6**

| | Atomic ratios in oxide sintered body | | | | | Relative density (%) |
|---|---|---|---|---|---|---|
| | Mg | Zn | X | Mg/(Zn+Mg) | X/(Zn+Mg+X) | |
| Ex. 7 | 0.534 | 0.371 | Ga:0.095 | 0.59 | 0.095 | 80 |
| Ex. 8 | 0.534 | 0.371 | Al:0.095 | 0.59 | 0.095 | 95 |
| Comp. Ex. 2 | 0.59 | 0.41 | 0 | 0.59 | 0 | 90 |
| Ex. 9 | 0.357 | 0.633 | Al:0.01 | 0.361 | 0.01 | 90 |
| Ex. 10 | 0.128 | 0.372 | Ga:0.500 | 0.256 | 0.50 | 85 |
| Ex. 11 | 0.534 | 0.463 | Al:0.003 | 0.536 | 0.003 | 90 |
| Ex. 12 | 0.533 | 0.460 | Al:0.007 | 0.537 | 0.007 | 90 |
| Ex. 13 | 0.532 | 0.458 | Al:0.01 | 0.537 | 0.01 | 94 |

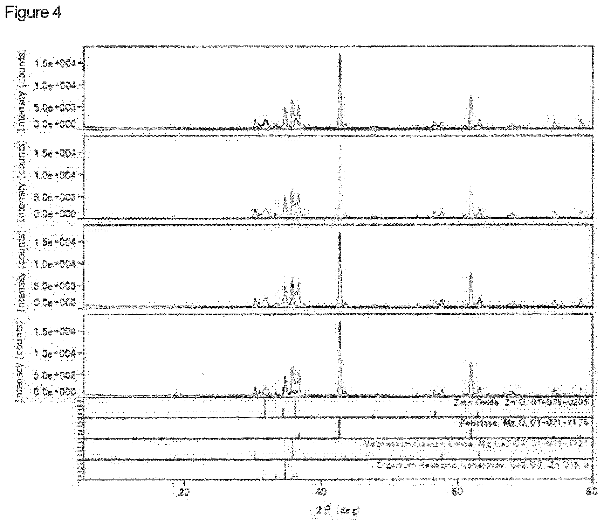

Fig. 4 shows a result of the analysis of the XRD chart. From Fig. 4, it was confirmed that the oxide sintered body contained ZnO (hexagonal), MgO (cubic), MgGa₂O₄, and Ga₂O₃(ZnO)₆ as crystal structures. Since the fitting ratio for Ga₂O₃(ZnO)₆ was poor, the presence of Ga₂O₃(ZnO)₆ was only presumed.

From the measured values and PDF values of lattice constants, the presence of MgO (cubic) into which Zn was solid-solved, ZnO (hexagonal) into which Mg was solid-solved, and MgX₂O₄ (X = Ga or Al) into which Zn was solid-solved was evaluated.

For the lattice constant "a" of MgO, the measured value was 4.2307 and the PDF value was 4.217. For the lattice constant "a" of ZnO, the measured value was 3.2482 and the PDF value was 3.242. For the lattice constant "a" of MgGa₂O₄, the measured value was 8.3121 and the PDF value was 8.26. Since the lattice constants are changed as described above, it is determined that Mg is solid-solved into ZnO, and Zn is solid-solved into MgO and MgGa₂O₄.

The results are shown in Table 7. In the table, the case where each crystal structure is contained is denoted by "○", and the case where each crystal structure is not contained is denoted by "×".

**Table 7**

| | MgO into which Zn was solid-solved | ZnO into which Mg was solid-solved (hexagonal) | MgX₂O₄ into which Zn was solid-solved X=Ga or Al |
|---|---|---|---|
| Ex. 7 | ○ | ○ | ○ |
| Ex. 8 | ○ | ○ | ○ |
| Comp. Ex. 2 | ○ | ○ | × |
| Ex. 9 | ○ | ○ | ○ |
| Ex. 10 | ○ | ○ | ○ |
| Ex. 11 | ○ | ○ | ○ |
| Ex. 12 | ○ | ○ | ○ |
| Ex. 13 | ○ | ○ | ○ |

### (B) Production of sputtering target

A sputtering target was produced and evaluated in the same manner as in Example 1, except that the oxide sintered body of Example 7 was used. The results are shown in Table 8.

**Table 8**

| | Ultraviolet transmittance (%) | Resistance (Ωcm) |
|---|---|---|
| Ex. 7 | 12 | 0.001 |
| Ex. 8 | 12 | 0.05 |
| Comp. Ex. 2 | 15 | 1000 |
| Ex. 9 | 10 | 0.001 |
| Ex. 10 | 18 | 0.1 |
| Ex. 11 | 18 | 1 |
| Ex. 12 | 18 | 0.5 |
| Ex. 13 | 18 | 0.05 |

### Examples 8 to 13, Comparative Example 2

Oxide sintered bodies and sputtering targets were produced and evaluated in the same manner as in Example 7 except that the raw materials were weighed and mixed so that the atomic ratio of each metal element was the value shown in Table 5. The results are shown in Tables 6 to 8. Incidentally, in Examples where the metal element X is Al, aluminum oxide having the average particle diameter of 1 µm or less (Al₂O₃ powder) was used.

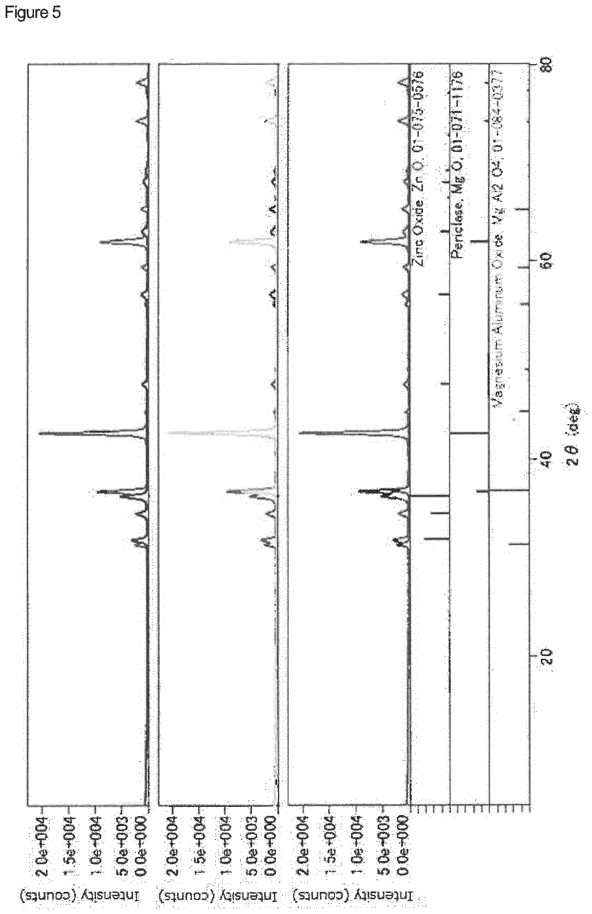

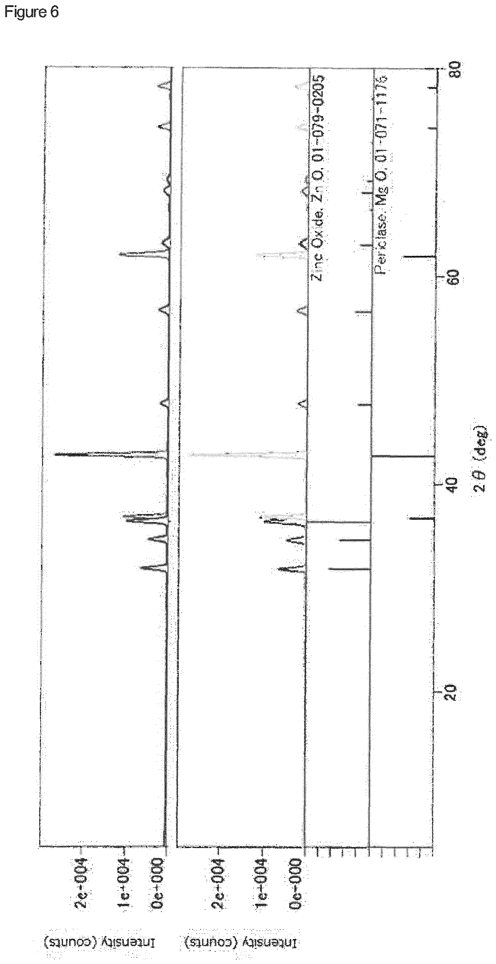

Fig. 5 shows a result of the analysis of the XRD chart of the oxide sintered body of Example 8. Fig. 6 shows a result of the analysis of the XRD chart of the oxide sintered body of Comparative Example 2.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese application(s) on the basis of which the present application claims Paris convention priority are incorporated herein by reference in its entirety.

## Claims

1. An oxide sintered body comprising zinc, magnesium, a positive trivalent or positive tetravalent metal element X, and oxygen as constituent elements, wherein
an atomic ratio of the metal element X to the sum of the zinc, the magnesium, and the metal element X [X/(Zn+Mg+X)] is 0.0001 or more and 0.6 or less, and
an atomic ratio of the magnesium to the sum of the zinc and the magnesium [Mg/(Zn+Mg)] is 0.25 or more and 0.8 or less.

2. The oxide sintered body according to claim 1, wherein the atomic ratio [Mg/(Zn+Mg)] is 0.625 or more and 0.8 or less.

3. The oxide sintered body according to claim 1, wherein the atomic ratio [Mg/(Zn+Mg)] is 0.626 or more and 0.75 or less.

4. The oxide sintered body according to claim 1, wherein the atomic ratio [Mg/(Zn+Mg)] is 0.628 or more and 0.74 or less.

5. The oxide sintered body according to any one of claims 2 to 4, comprising cubic MgO into which Zn is solid solved, and MgX₂O₄ into which Zn is solid-solved, wherein X is a positive trivalent metal element.

6. The oxide sintered body according to claims 1, wherein the atomic ratio [Mg/(Zn+Mg)] is 0.25 or more and less than 0.625.

7. The oxide sintered body according to claim 1, wherein the atomic ratio [Mg/(Zn+Mg)] is 0.30 or more and 0.60 or less.

8. The oxide sintered body according to claim 1, wherein the atomic ratio [Mg/(Zn+Mg)] is 0.40 or more and 0.59 or less.

9. The oxide sintered body according to any one of claims 6 to 8, comprising cubic MgO into which Zn is solid-solved, hexagonal ZnO into which Mg is solid-solved, and MgX₂O₄ into which Zn is solid-solved, wherein X is a positive trivalent metal element.

10. The oxide sintered body according to any one of claims 1 to 9, wherein the atomic ratio [X/(Zn+Mg+X)] is 0.003 or more and 0.6 or less.

11. The oxide sintered body according to any one of claims 1 to 9, wherein the atomic ratio [X/(Zn+Mg+X)] is 0.007 or more and 0.5 or less.

12. The oxide sintered body according to any one of claims 1 to 9, wherein the atomic ratio [X/(Zn+Mg+X)] is 0.008 or more and 0.5 or less.

13. The oxide sintered body according to any one of claims 1 to 9, wherein the atomic ratio [X/(Zn+Mg+X)] is 0.01 or more and 0.5 or less.

14. The oxide sintered body according to any one of claims 1 to 13, wherein X is at least one of Al and Ga.

15. The oxide sintered body according to claim 14, wherein X is Al.

16. The oxide sintered body according to claim 14, wherein X is Ga.

17. A material for film formation, comprising the oxide sintered body according to any one of claims 1 to 16.

18. The material for film formation according to claim 17, which is a tablet for film formation.

19. The material for film formation according to claim 17, which is a sputtering target.

20. A thin film obtained by using the material for film formation according to any one of claims 17 to 19.
